# EUROPEAN PATENT APPLICATION

(11) **EP 3 509 089 A1**
(43) Date of publication of application: **10.07.2019**
(21) Application number: 17846451.7
(22) Date of filing: 29.08.2017
(51) Int. Cl.: H01L 21/31, C23C 16/44, H01L 21/3065

(54) **METHOD FOR CLEANING SEMICONDUCTOR PRODUCTION CHAMBER**

(30) Priority: 31.08.2016 JP 2016169562
(71) Applicant: National University Corporation Yokohama National University, Yokohama-shi, Kanagawa 240-8501 (JP); Kanto Denka Kogyo Co., Ltd., Chiyoda-ku Tokyo 101-0063 (JP)
(72) Inventor: HABUKA, Hitoshi, Yokohama-shi Kanagawa 240-8501 (JP); TAKAHASHI, Yoshinao, Tokyo 101-0063 (JP); FUKAE, Katsuya, Shibukawa-shi Gunma 377-8513 (JP)
(74) Representative: Plougmann Vingtoft a/s
(86) International application number: PCT/JP2017/030835
(87) International publication number: WO 2018/043446

(57) **Abstract**

A method for effectively removing fluorine atoms remaining in a semiconductor fabrication chamber after cleaning the chamber with chlorine trifluoride is provided. The method includes exposing the inside of the chamber after semiconductor fabrication to chlorine trifluoride to remove an object to be removed remaining in the chamber and then thermally treating the inside of the chamber with at least one gas selected from the group consisting of nitrogen, argon, helium, and hydrogen. It is preferred that the exposure to chlorine trifluoride is carried out while monitoring the chamber inside temperature and that the chlorine trifluoride feed is ceased when the inside temperature decreases to a predetermined temperature.

## Description

### Technical Field

The present invention relates to a method for cleaning a semiconductor fabrication chamber.

### Background Art

In the manufacture of semiconductor wafers or devices by chemical vapor deposition (CVD) process, it is known that scale forms on the inner wall and Jigs disposed in a DVD chamber. An acid cleaning process has been used to remove the scale. However, scale removal by acid cleaning is labor-intensive and forms a bottleneck in improving productivity in the semiconductor fabrication. To solve this problem, changeover from acid cleaning to gas cleaning has been proposed for scale removal.

Gases known for use in gas cleaning include fluorine-containing gases used to remove the scale formed in the fabrication of semiconductors typified by Si or SiNₓ, such as chlorine trifluoride (ClF₃), nitrogen trifluoride (NF₃), carbon tetrafluoride (CF₄), and sulfur hexafluoride (SF₆). These gases provide cleaning performance in a plasma condition. Among them chlorine trifluoride attracts particular attention as a cleaning gas because it is capable of easily releasing fluorine atoms necessary for cleaning even in a non-plasma condition.

With regard to the use of chlorine trifluoride as a cleaning gas for semiconductor fabrication chambers, Non-Patent Literature 1 below proposes cleaning a SiC epitaxial reactor using chlorine trifluoride to remove SiC deposited on the surface of the susceptor. Patent Literature 1 below also discloses the same technique.

Non-Patent Literature 2 below reports the surface chemical condition of SiC after etching using chlorine trifluoride, suggesting that chlorine atoms and fluorine atoms originated in chlorine trifluoride remain after etching.

### Citation List

### Patent Literature

Patent Literature 1: JP 2016-66658A

### Non-Patent Literature:

Non-Patent Literature 1: ECS J. Solid State Sci. Technol., 5(2016), pp. 12-15
Non-Patent Literature 2: Japanese Journal of Applied Physics, 44 (2005), pp. 1376-1381

### Summary of Invention

Chlorine atoms or fluorine atoms remaining in a semiconductor fabrication chamber after cleaning the chamber using chlorine trifluoride can come to be mixed in a film formed in the chamber as impurities and deteriorate the film qualities. These residual atoms can also contribute to corrosion of jigs disposed in the chamber, such as a susceptor. This problem is particularly conspicuous when fluorine atoms remain in the chamber.

An object of the present invention is to improve the method for cleaning a semiconductor fabrication chamber and, more particularly, to eliminate disadvantages associated with fluorine atoms remaining after cleaning.

The present invention solves the above problem by the provision of a method for cleaning a semiconductor fabrication chamber comprising exposing the inside of the chamber after semiconductor fabrication to chlorine trifluoride to remove an object to be removed remaining in the chamber and thermally treating the inside of the chamber with at least one gas selected from the group consisting of nitrogen, argon, helium, and hydrogen.

### Brief Description of Drawings

Fig. 1 is a schematic view showing a method for cleaning an exhaust tube connected to a semiconductor fabrication chamber.
Fig. 2 is a graph showing exemplary results of monitoring the temperature of the exhaust tube by the method of Fig. 1.
Fig. 3 is a schematic view showing a testing device for confirming removal of residual fluorine atoms by the cleaning method of the present invention.

### Description of Embodiments

The present invention will be described on the basis of its preferred embodiments. The present invention relates to a method for cleaning a semiconductor fabrication chamber after semiconductor fabrication. As used herein, the term "semiconductor" is used in its broadest sense to include various products composed of a semiconducting material, such as semiconductor wafers and semiconductor devices. The types of semiconductors are not particularly limited, and the cleaning method of the present invention is applicable to fabrication of a variety of semiconductors. Examples of semiconductors include Si, SiC, GaN, Ge, GaP, GaAs, ZnS, ZnSe, and diamond. As used herein, the phrase "cleaning a semiconductor fabrication chamber" is intended to mean removing the scale deposited in the inside of the chamber and removing the scale deposited on the jigs disposed in the chamber. The jigs in the chamber typically include, but are not limited to, a susceptor. The susceptor material may be selected as appropriate according to the type of the semiconductor to be fabricated. For example, a carbon-made susceptor may be used for the fabrication of SiC as a semiconductor. The carbon-made susceptor may be coated with a different material, such as pyrolytic carbon.

The cleaning method of the present invention is applied to removal of the scale deposited inside a semiconductor fabrication chamber or the scale deposited on the jigs disposed in the chamber. The scale, which is an object to be removed, is a substance unintentionally deposited in a process for fabricating a semiconductor, for example, a substance composed of the semiconductor. As an example for reference, in the case of conducting SiC epitaxial growth by the chemical vapor deposition (CVD) process using semiconductor fabrication chamber, SiC is deposited as a scale on the inner wall of the chamber and on the surface of the susceptor.

The cleaning method of the present invention uses chlorine trifluoride (ClF₃) gas for removing scale which is an object to be removed. Chlorine trifluoride gas can be fed to a chamber at a concentrate of 100% without dilution of other gases. Alternatively, it may be fed to the chamber in the conditions diluted with other various inert gases, such as nitrogen. Chlorine trifluoride gas may be fed to the chamber either in a continuous flow or batchwise. With a view to increasing the scale removal efficiency, chlorine trifluoride gas is preferably fed to the chamber in a continuous flow.

Scale removal using chlorine trifluoride is preferably conducted while heating the space to be cleaned from the viewpoint of scale removal efficiency. With this view, the heating temperature is preferably from room temperature (25°C) to 500°C, more preferably 300° to 480°C. Provided that the heating temperature is in that range, the cleaning time is preferably 1 minute to 2 hours, more preferably 1 to 10 minutes.

The inside of a semiconductor fabrication chamber is usually invisible. Therefore, the cleaning end point is not visually determined. In the case of continuous flow feed of chlorine trifluoride gas, to continue feeding chlorine trifluoride gas after completion of cleaning is not only uneconomical but also can cause damage to the inner wall of the chamber or the jig disposed in the chamber. It is thus beneficial to know a cleaning end point in some way. For this purpose, the inventors have conducted intensive investigation and found as a result that scale removal using chlorine trifluoride gas is accompanied by heat generation as a result of the reaction between the gas and the scale and that the cleaning end point can be identified through monitoring the heat. Specifically, it is beneficial to dispose a temperature monitoring means at any position within the chamber to enable monitoring the temperature inside the chamber during cleaning. That is, the cleaning method of the present invention includes to advantage steps of exposing the inside of the chamber to chlorine trifluoride gas while monitoring the inside temperature and ceasing the chlorine trifluoride gas feed to the chamber when the temperature being monitored decreases to a predetermined temperature.

In connection with chlorine trifluoride gas feed in a continuous flow, the temperature monitoring means is preferably placed in the chamber at the junction with an exhaust tube. In other words, the temperature monitoring means is preferably disposed at the most downstream position of the chlorine trifluoride gas flow path within the chamber. By this configuration, the heat produced by the reaction between chlorine trifluoride gas and scale is measured accurately.

The temperature monitoring means is preferably such that is able to accurately read temperature in a chlorine trifluoride gas atmosphere. From this standpoint, it is advantageous to use a crystal oscillator as a temperature monitoring means. Seeing that the oscillation frequency of a crystal oscillator is sensitively responsive to changes in temperature, the temperature at the site of the crystal oscillator can be obtained by measuring the oscillation frequency. With a view to preventing the crystal oscillator from being corroded, it is preferred to protect the surface of the crystal oscillator with a film resistant to corrosion at room temperature, such as a SiC film. A protective film thickness of several nanometers would be enough. The electrode materials used to oscillate the crystal oscillator are ,if the materials form a fluoride, preferably made of a material whose fluoride has a high melting temperature and a high boiling temperature. Such a material is exemplified by chromium or aluminum.

The standard for determining whether cleaning is completed on the basis of temperature monitoring in the camber is, for example, whether the temperature inside the chamber or the temperature at the exhaust outlet from the chamber becomes almost constant. Temperature measurement can be taken using, for example, a thermocouple or a crystal oscillator.

In semiconductor fabrication by CVD processing, various substances may deposit on the inner wall of an exhaust tube connected to a (CVD) chamber. For example, in SiC epitaxial growth by CVD processing, SiC, Si, or C powder, chlorosilane, and so on can be adhered as a scale on the inner wall of the exhaust tube to clog the tube. The scale is composed of a powdered substance and/or oily substance. In particular, oily scale is often composed mainly of chlorosilane. There is a danger of chlorosilane igniting and burning on exposure to air. Powdered scale can also ignite and burn on exposure to air. The scale of these kinds often deposits over a distance of several meters from the outlet of the chamber. Hence, it is desirable that not only the scale in the chamber but also that in the exhaust tube connected to the chamber be removed by the exposure to chlorine trifluoride.

Exposure of the exhaust tube to chlorine trifluoride gas can be achieved by, for example, (i) utilizing the chlorine trifluoride gas to which the chamber has been exposed. Instead of this, (ii) chlorine trifluoride gas may be fed to the exhaust tube separately from the gas fed to the chamber. The method (ii) is advantageous in that the concentration of the chlorine trifluoride gas fed to the chamber and that to the exhaust tube are separately regulated so that scale removal is achieved more precisely. In adopting the method (ii), introducing chlorine trifluoride gas is preceded by purging the combustible gas from the chamber and the exhaust tube with an inert gas. Chlorine trifluoride gas may be introduced through a gas inlet of the chamber or may be introduced not into the chamber but only into the upstream end of the exhaust tube.

Similarly to the semiconductor fabrication chamber, the inside of the exhaust tube connected to the chamber is also invisible from the outside. Therefore, the end point of cleaning the exhaust tube is not visually determined. In the case of continuous flow feed of chlorine trifluoride gas, to continue feeding chlorine trifluoride gas after the completion of cleaning is uneconomical. It is thus beneficial to know a cleaning end point in some way. For this purpose, it is advantageous to monitor the temperature inside the exhaust tube during the exposure of the exhaust tube to chlorine trifluoride and cease the chlorine trifluoride gas feed to the exhaust tube when the temperature being monitored decreases to a predetermined temperature in the same manner as for the chamber cleaning as mentioned above.

In connection with chlorine trifluoride gas feed in a continuous flow, the temperature monitoring means for monitoring the temperature inside the exhaust tube is preferably placed at least at the most downstream position of the exhaust tube. In other words, the temperature monitoring means is preferably disposed at the most downstream position of the chlorine trifluoride gas flow path within the exhaust tube. By this configuration, the heat produced by the reaction between chlorine trifluoride gas and scale is measured accurately.

The number of the temperature monitoring means placed in the exhaust tube is not particularly limited. That is, a plurality of temperature monitoring means may be installed within the exhaust tube, or one or more temperature monitoring means may be installed to the exterior surface of the tube to read the temperature at one or more sites of the tube.

As a temperature monitoring means for the exhaust tube, a crystal oscillator may be used as is used for the chamber. Otherwise, a thermocouple may be used. A combination of a crystal oscillator and a thermocouple may also be used as a temperature monitoring means When using a thermocouple, it is preferably placed not inside the exhaust tube but on the exterior surface of the tube with a view to preventing corrosion.

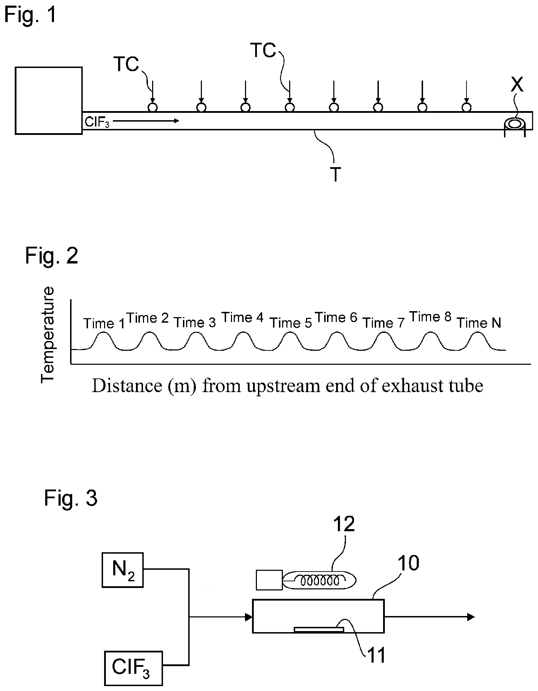

Fig. 1 illustrates an embodiment of installing a temperature monitoring means to an exhaust tube. In Fig. 1, a plurality of thermocouples TC are installed on the exterior surface of an exhaust tube T at a predetermined interval, for example, at an approximately equal interval, and a crystal oscillator X is placed inside the tube at the most downstream location. The thermocouples TC may be replaced with surface thermometers or thermolabels.

Chlorine trifluoride gas generates heat on reacting with silicon even at room temperature and chlorine trifluoride gas generates heat on reacting with carbon at elevated temperatures above about 100° to 200°C. On the other hand, it noticeably reacts with SiC to generate heat at temperatures from above 300° to 400°C. These properties are taken advantage of to monitor the progress of cleaning inside the exhaust tube.

The monitoring starts with introducing chlorine trifluoride gas diluted with nitrogen to a concentration of 1 to 50 vol% into the exhaust tube T at a very small rate, e.g., about 10 cc/min, and the temperature near the gas inlet is measured. With the chlorine trifluoride gas feed at a low flow rate, reaction between silicon and chlorosilane occurs to generate heat, and with the heat generated carbon starts reacting to generate heat. Thereby further occurring to generate heat, the temperature locally reaches a level allowing SiC to react. Because the reaction products, i.e., silicon fluoride and carbon fluoride, are low-boiling substances, they all turn into gas and clear out. Too high a chlorine trifluoride concentration is dangerous in that the temperature of the generated heat excessively rises. At too low a concentration the temperature does not reach the level causing SiC to react. Therefore, it is necessary to select appropriate concentration and flow rate of chlorine trifluoride gas. For example, when chlorine trifluoride gas diluted with nitrogen to 10 vol% is fed at 10 cc/min, the site where a reaction takes place has an elevated temperature, and the site where a reaction has ended and the site where a reaction has not yet started show no temperature elevation. Thus, the location of the ongoing reaction is easily figured out by tracing the exterior surface temperatures of the exhaust tube T using the thermocouples TC. Fig. 2 displays an example of the temperature monitoring. As shown, the position of temperature elevation shifts from the upstream to downstream locations of the exhaust tube T with the passage of time from time 1, to time 2,···, to time N. This indicates that the site of the reaction with chlorine trifluoride gas shifts from upstream to downstream with time.

The concentration of chlorine trifluoride gas fed to the exhaust tube T is preferably regulated so that the temperature measured on the outer surface of the tube T may not exceed 100°C. In addition to, or instead of, this, the flow rate of the chlorine trifluoride/nitrogen mixed gas is preferably regulated so that the temperature measured on the outer surface of the tube T may not exceed 100°C. The cleaning is determined to have completed when no temperature elevation as indicated in Fig. 2 is observed any more.

The above illustrated technique is for determining the cleaning end point by using thermocouples TC installed to the exterior surface of the exhaust tube T. In addition to this, the cleaning end point can be determined by using the crystal oscillator X disposed inside the exhaust tube T as follows. The crystal oscillator X can be designed to have its frequency, e.g., 25 MHz increased or decreased with a rise in temperature and is therefore able to measure temperature changes sensitively. The temperature of the gas having reached to a sufficiently downstream site of the exhaust tube T is measured while feeding chlorine trifluoride gas to the exhaust tube T. As described above, the gas temperature gradually increases as the reaction site shifts downstream in the exhaust tube T, but the temperature of the gas reaching the crystal oscillator X decreases as a result of scale removal from the exhaust tube T. Removal of all the scale from the exhaust tube T is thus determined by this temperature decrease.

When chlorine trifluoride is consumed by the chemical reactions to form gaseous low molecular weight substances, such as silicon fluoride and carbon fluoride, the density and viscosity of the gas reaching the crystal oscillator X reduce. It is known that the frequency of a crystal oscillator is responsive to the product of the density and viscosity of gas. The frequency of the crystal oscillator increases with the consumption of chlorine trifluoride by the reactions. Therefore, the crystal oscillator X enables indirect determination of the gas composition as well as gas temperature measurement. Upon removal of the scale inside the exhaust tube T, the gas reaching the crystal oscillator X again increases in density and viscosity and thereby reduces in frequency, whereby scale removal is judged to be completed.

Cleaning of the inside of the semiconductor fabrication chamber and/or the inside of the exhaust tube connected to the chamber is thus completed through the above operations. After completion of the cleaning, although the scale has been removed from the inside of the chamber and the exhaust tube, fluorine atoms originated in chloride trifluoride used for scale removal may remain inside. Remaining fluorine atoms can enter the film produced afterward as impurity and may cause deterioration in film qualities. Remaining fluorine atoms can also corrode the susceptor made of carbon and the like. It is therefore preferred in the present invention that ceasing the chlorine trifluoride gas feed on completion of cleaning inside the chamber and/or the exhaust tube be followed by thermally treating the inside of the chamber and/or the exhaust tube with at least one gas selected from the group consisting of nitrogen, argon, helium, and hydrogen. By the thermal treatment in such a gas atmosphere, fluorine vaporizes and is driven out of the system.

With a view to ensuring fluorine be removed by vaporization, the thermal treatment temperature is preferably set higher than the temperature at which the inside of the chamber and/or the inside of the exhaust tube are exposed to chlorine trifluoride gas irrespective of the kind of the gas. Specifically, when the temperature of exposure to chlorine trifluoride is in the range of from room temperature (25°C) to 500°C, the thermal treatment temperature is preferably 500° to 1700°C, more preferably 900° to 1600°C, provided that it is higher than the temperature of exposure.

With the same view, in the case when SiC as a semiconductor is fabricated by a CVD process, the thermal treatment is preferably carried out at a temperature equal to or higher than the SiC fabrication temperature. Specifically, when the temperature of SiC fabrication is in the range of from 1500° to 1700°C, the thermal treatment temperature is preferably 1500° to 2000°C, more preferably 1500° to 1700°C, provided that it is equal to or higher than the SiC fabrication temperature.

The thermal treatment time is preferably 1 to 60 minutes, more preferably 1 to 10 minutes, provided that the thermal treatment temperature is in the above range.

The thermal treatment atmosphere may be at least one of the above recited gases. Two or more of nitrogen, argon, and helium may be used in combination. Hydrogen is preferably used alone. In the case of using hydrogen, after stopping the feed of chlorine trifluoride gas to the system, it is preferred that hydrogen introduction be preceded by certainly removing chlorine trifluoride gas remaining in the system by, for example, purging. Purging the residual chloride trifluoride gas from the system may be achieved by, for example, evacuating the chamber to vacuum before hydrogen introduction as an atmosphere gas, or by feeding an inert gas, such as nitrogen, argon, or helium, through the system for a certain period of time (e.g., 10 minutes), followed by introducing hydrogen as an atmosphere gas. Feeding an inert gas may be performed with or without heat, e.g., at room temperature (25°C). The gas for thermal treatment may be fed to the chamber either in a continuous flow or batchwise.

Any residual fluorine remaining in the semiconductor fabrication chamber and/or the exhaust tube connected thereto is certainly removed through the above described operation. Whether fluorine atoms have been removed may be confirmed by any methods, such as XPS. Fig. 3 is a schematic illustration of a testing device for confirming removal effect of residual fluorine atoms of the present invention. In Fig. 3, a numerical reference 10 indicates a quartz-made chamber. The chamber 10 has a volumetric capacity of 200 cm³. In the chamber 10 is placed a high-purity carbon-made specimen 11 as a model susceptor. The specimen 11 has a SiC coating, which serves as model scale. A halogen lamp 12 is disposed outside the chamber 10 in a facing relation to the chamber 10.

With the inside of the chamber 10 being heated to 450°C using the halogen lamp 12, 100 vol% chlorine trifluoride gas was continuously fed to the chamber 10 at a rate of 50 sccm. The inner pressure of the chamber was regulated at 1 atm. After the chlorine trifluoride gas was fed for 10 minutes, the halogen lamp 12 was turned off, at the same time, the gas feed was stopped. Nitrogen gas was then fed to the chamber 10 at a rate of 1000 sccm to purge the chlorine trifluoride gas remaining in the chamber 10. While continuing nitrogen gas feed at a rate of 1000 sccm, the halogen lamp 12 was turned on to heat the inside of the chamber 10 to 900°C. The nitrogen gas feed under heat was continued for 10 minutes to vaporize and remove fluorine atoms remaining on the specimen 11. Thereafter, feeding nitrogen gas was stopped and the halogen lamp 12 was turned off. After the chamber 10 cooled down, the specimen 11 was taken out from the chamber 10 and analyzed by XPS to determine the amount of fluorine atoms remaining on the surface of the specimen 11.

For comparison, the same analysis was also conducted on the specimen after stopping the chlorine trifluoride gas feed and before heating in a nitrogen gas atmosphere.

Another experiment was performed using hydrogen gas in place of nitrogen gas as follows. Nitrogen gas was fed to the chamber at room temperature at a rate of 1000 sccm for 10 minutes to purge any chlorine trifluoride remaining in the system. Hydrogen gas was then fed to the system at a rate of 1000 sccm. The inside temperature of the chamber 10 was kept at 1100°C. The hydrogen gas feed under heat was continued for 10 minutes thereby to vaporize and remove fluorine atoms remaining on the specimen 11. Thereafter, the specimen 11 was taken out and analyzed by XPS in the same manner as above to determine the amount of fluorine atoms remaining on the surface of the specimen 11. The results obtained are shown in Table 1 below.

**Table 1**

| | Results of XPS |
|---|---|
| Thermal treatment in N₂ atmosphere (invention) | 0.2% |
| Thermal treatment in H₂ atmosphere (invention) | below detection limit |
| No thermal treatment (comparison) | 49% |

As is apparent from the results in Table 1, the fluorine atoms remaining on the specimen 11 after the removal of SiC from the surface of the specimen 11 using chlorine trifluoride gas is reduced by the following thermal treatment in a nitrogen or hydrogen atmosphere as compared with the SiC removal without being followed by a thermal treatment. It is seen, in particular, that the thermal treatment in a hydrogen atmosphere achieves fluorine (atoms) removal to below the detection limit. The inventors have confirmed that such a trace amount of remaining fluorine atoms gives no adverse influences on ensuing SiC fabrication.

### Industrial Applicability

The present invention enables effective removal of fluorine atoms remaining after cleaning a semiconductor fabrication chamber with chlorine trifluoride.

## Claims

1. A method for cleaning a chamber for semiconductor fabrication comprising exposing the inside of the chamber after semiconductor fabrication to chlorine trifluoride to remove an object to be removed remaining in the chamber and then thermally treating the inside of the chamber with at least one gas selected from the group consisting of nitrogen, argon, helium, and hydrogen.

2. The method according to claim 1, wherein exposure to chlorine trifluoride is conducted while monitoring the temperature inside the chamber, and the method further comprises ceasing the chlorine trifluoride gas feed to the chamber when the temperature being monitored decreases to a predetermined temperature.

3. The method according to claim 2, wherein the chamber has an exhaust tube connected thereto, and monitoring the temperature inside the chamber is carried out with a temperature monitoring means placed in the chamber at the junction with the exhaust tube.

4. The method according to claim 3, wherein a crystal oscillator is used as the temperature monitoring means.

5. The method according to any one of claims 1 to 4, wherein the chamber has an exhaust tube connected thereto, and the method further comprises exposing the inside of the exhaust tube to chlorine trifluoride.

6. The method according to claim 5, wherein exposure of the inside of the exhaust tube to chlorine trifluoride is conducted while monitoring the temperature inside the tube, and the method further comprises ceasing the chlorine trifluoride gas feed to the exhaust tube when the temperature being monitored decreases to a predetermined temperature.

7. The method according to claim 6, wherein monitoring the temperature inside the exhaust tube is carried out with a temperature monitoring means placed inside the exhaust tube.

8. The method according to claim 7, wherein a crystal oscillator is used as the temperature monitoring means.

9. The method according to any one of claims 1 to 8, wherein the thermal treatment temperature is set higher than the temperature at which the inside of the chamber is exposed to chlorine trifluoride.

10. The method according to any one of claims 1 to 9, wherein the semiconductor comprises SiC.

11. The method according to any one of claims 1 to 10, wherein the chamber contains a susceptor, and the susceptor is to be cleaned.

12. The method according to claim 11, wherein the susceptor comprises carbon.
